# EUROPEAN PATENT APPLICATION

(11) **EP 0 891 124 A2**
(43) Date of publication of application: **13.01.1999**
(21) Application number: 98112346.6
(22) Date of filing: 03.07.1998
(51) Int. Cl.: H05K 1/00, H05K 3/20, H01R 9/24

(54) **Three-dimensional electrical interconnection system**

(30) Priority: 10.07.1997 JP 200808/97
(71) Applicant: MOLEX INCORPORATED, Lisle Illinois 60532 (US)
(72) Inventor: Kunishi, Shinsuke, Kanagawa (JP); Yamaguchi, Shigetoshi, Isehara-shi, Kanagawa (JP)
(74) Representative: Blumbach, Kramer & Partner GbR

(57) **Abstract**

A molded electrical interconnection system (1) includes a three-dimensional molded dielectric substrate (2) including at least first and second separate substrate sections (2a,2b). Stamped and formed electrical circuitry (10) are embedded in the molded substrate (2) and include contact portions (4,6,7) projecting from the substrate and circuit portions (3) extending between and joining the separate substrate sections. The circuit portions (3) thereby act as a hinge allowing at least angular relative movement between the substrate sections (2a,2b) in response to bending of the circuit portions.

## Description

### Field of the Invention

This invention generally relates to the art of electrical connectors and, particularly, to a molded electrical interconnection system which has stamped and formed electrical circuitry.

### Background of the Invention

Printed circuit boards have been used for many years in the electrical industry. A typical printed circuit board includes a flat (versus three-dimensional) substrate having a pattern of circuit traces printed or otherwise deposited thereon. Electronic components are electrically coupled to the circuit traces on one or both sides of the flat substrate by solder connections to contact pads of the circuit traces. Often, solder tails from the electrical components are inserted into holes in the flat substrate, and the tails are soldered to the circuit traces on the board and/or in the holes. These solder connections require expensive and often tedious processes. If a solder connection becomes damaged, its repair also is expensive and tedious.

In some electrical fields, such as in the automotive industry, three-dimensional circuit structures have been developed wherein a plurality of stamped and formed conductors are embedded, as by overmolding, in a three-dimensional molded dielectric substrate. Typically, the conductors have contact tabs or blades which project from the substrate. In some instances, the contact tabs or blades may be disposed in recesses in the substrate. The molded substrate is designed to permit mounting of electrical devices or parts thereon, such as relays, switches, terminal blocks, terminal boards or the like, making required electrical connections between the devices or parts through the conductors embedded in the substrate. Various interconnection schemes are designed to eliminate the expensive solder connections of typical printed circuit boards. However, these three-dimensional circuit structures have problems of limited applications due to their rigidity, particularly in environments where space is limited and large, totally planar three-dimensional circuit structures are difficult to use. The present invention is directed to solving these problems by providing a unique, flexible three-dimensional circuit structure not heretofore provided.

### Summary of the Invention

An object, therefore, of the invention is to provide a new and improved electrical interconnection system, such as a three-dimensional molded interconnection system.

In the exemplary embodiment of the invention, the system includes a three-dimensional molded dielectric substrate including at least first and second substrate sections. The sections are hingedly interconnected to provide at least angular relative movement therebetween. Stamped and formed electrical circuitry are embedded in the molded substrate and include contact portions projecting from the substrate for interconnection to outside electrical devices or parts. Circuit portions of the stamped and formed electrical circuitry extend between the hinged substrate sections. In the preferred embodiment, these circuit portions join the separate substrate sections and provide the hinge means to allow the relative angular movement therebetween.

As disclosed herein, the separate substrate sections are generally planar. At least one of the substrate sections includes at least one open socket with one of the contact portions of the circuitry disposed therewithin. In the preferred embodiment, the contact portions in the open sockets are formed female contacts of the circuitry.

By providing two distinct or separate substrate sections, one section can act effectively as a type of plug section and the other section can act as a type of female section. In other words, the contact portions of the circuitry projecting from the first substrate section can substantially comprise male contacts, and the contact portions of the circuitry projecting from the second substrate section can comprise substantially female contacts.

Other objects, features and advantages of the invention will be apparent from the following detailed description taken in connection with the accompanying drawings.

### Brief Description of the Drawings

The features of this invention which are believed to be novel are set forth with particularity in the appended claims. The invention, together with its objects and the advantages thereof, may be best understood by reference to the following description taken in conjunction with the accompanying drawings, in which like reference numerals identify like elements in the figures and in which:
FIGURE 1 is a perspective view of a three-dimensional molded circuit structure according to the invention;
FIGURE 2 is a top plan view of the circuit structure;
FIGURE 3 is a side or edge view of the circuit structure;
FIGURE 4 is an end elevational view of the circuit structure;
FIGURE 5 is a top plan view of the electrical circuitry in stamped or blank form prior to forming the contact portions;
FIGURE 6 is a view similar to that of Figure 5, with the contact portions formed into the final configuration of the circuitry;
FIGURE 7 is a side or edge elevational view of the circuitry, looking toward the rear of Figure 6;
FIGURE 8 is an end elevational view of the circuitry, looking toward the right-hand end of Figure 6;
FIGURE 9 is a fragmented section through one of the female contact portions of the circuitry, with a protection piece therefore; and
FIGURE 10 is a view similar to that of Figure 9, but showing another embodiment of a protection piece having a guide channel to the female contact portion.

### Detailed Description of the Preferred Embodiment

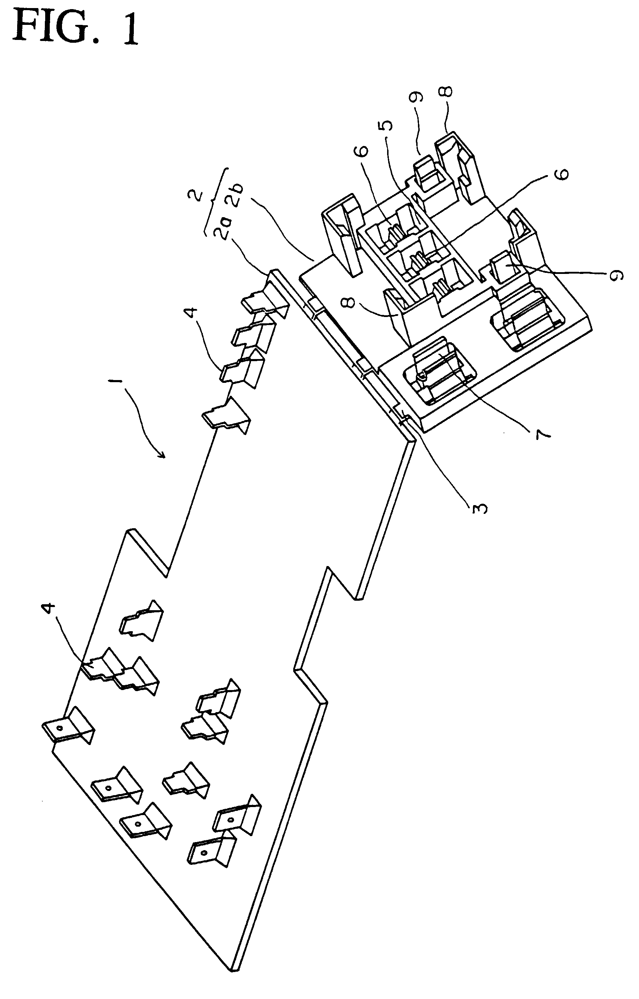

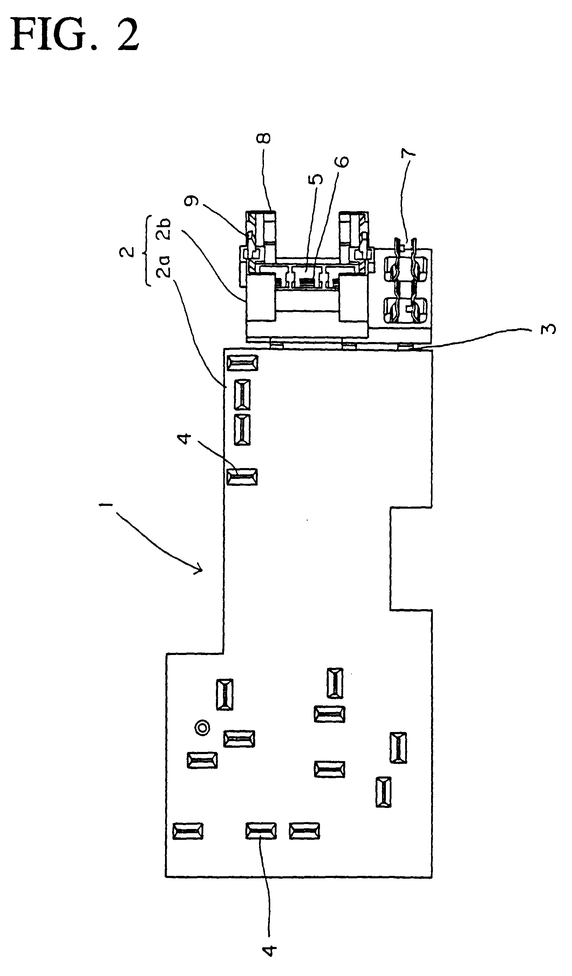

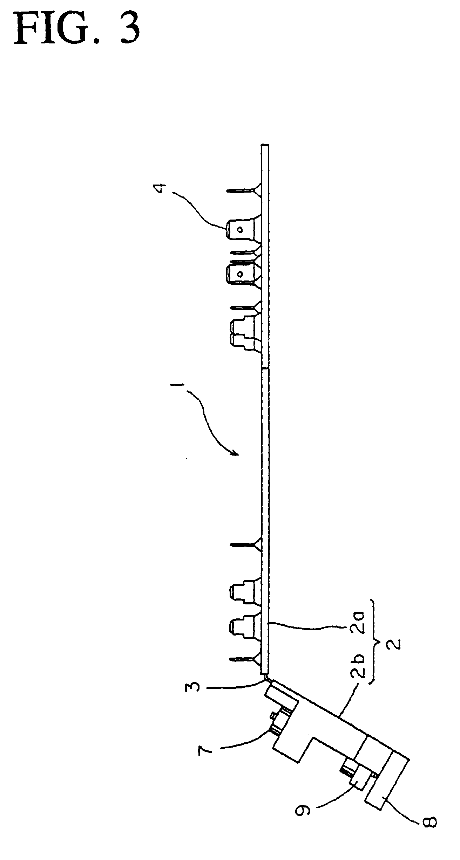

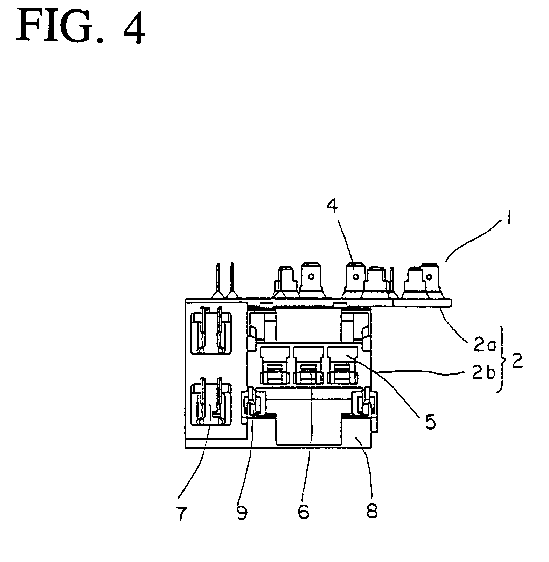

Referring to the drawings in greater detail, and first to Figures 1-4, the concepts of the invention are embodied in a three-dimensional molded electrical interconnection system or circuit structure, generally designated 1. The interconnection system includes a three-dimensional molded dielectric substrate 2 which includes at least first and second separate substrate sections 2a and 2b. Of course, it should be understood that more than two separate substrate sections are contemplated by the invention. The substrate sections are separated from each other along generally parallel edges 2c defining a gap 2d between the sections. The two sections are hingedly interconnected, as described hereinafter, for allowing at least angular relative movement between the sections.

The three-dimensional molded dielectric substrate 2, including substrate sections 2a and 2b, is overmolded about stamped and formed electrical circuitry embedded in the molded substrate. The circuitry includes circuit portions or conductors 3, with integral male contacts or blades 4 and integral female contacts 6 and 7. Molded section 2b has integral recesses 5 for accommodating female contacts 6. Substrate section 2b also has four upright guide posts 8 and a pair of latches 9 for mounting a terminal block, for instance, to separate substrate section 2b. The terminal block would have all male contacts. On the other hand, it can be seen that all of the contacts on separate substrate section 2a are male contacts or blades. These male contacts could be used for interconnecting electronic components to separate section 2a, the components having all female contacts.

Figures 1-3 show a unique feature of the invention whereby circuit portions or conductors 3 of the embedded stamped and formed electrical circuitry form the hinge means for hingedly connecting the two substrate sections. In other words, conductors 3 not only interconnect male contacts 4 with female contacts 6 and 7 (as seen hereinafter), but the conductors join the separate substrate sections 2a and 2b and allow at least angular relative movement between the substrate sections as the conductors bend and act as a living hinge means.

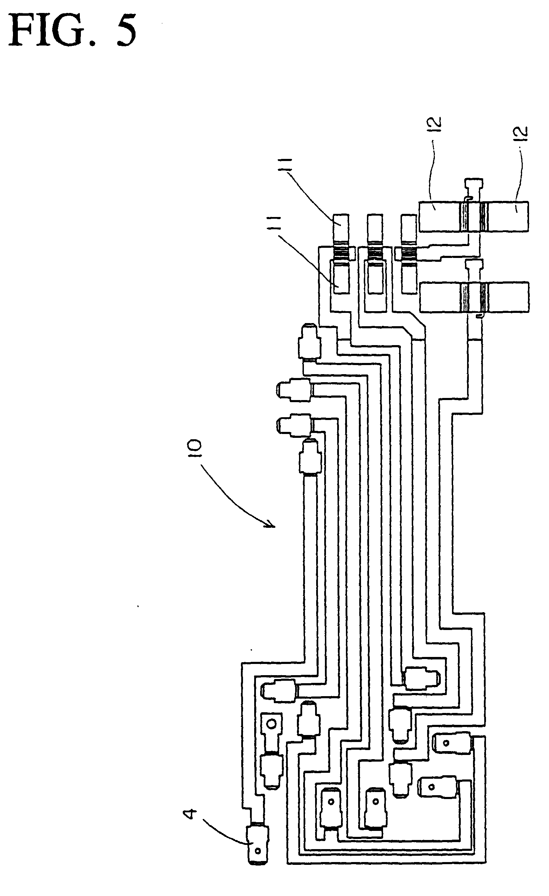

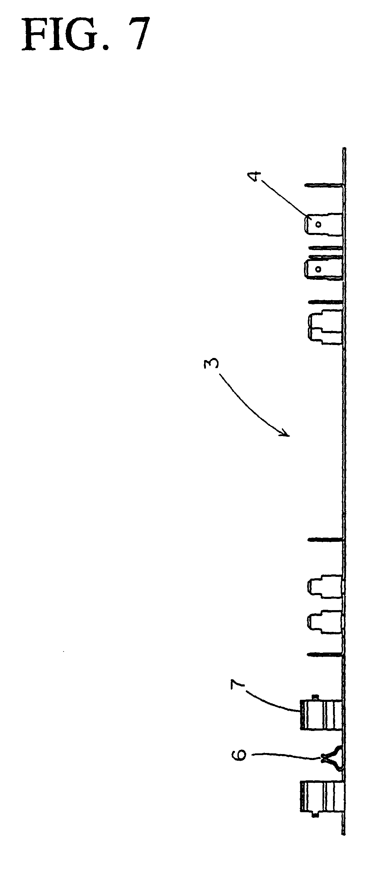

Figures 5-8 show electrical circuitry 10 which is embedded in substrate sections 2a and 2b as described above. Figure 5 shows the circuitry in a preliminary or blank form wherein circuit portions or conductors 3 and male contacts 4 are stamped out of a sheet of conductive material, such as metal or the like. Contact arms 11 and 12 also are stamped out of the sheet metal material, with arms 11 eventually becoming female contacts 6 and arms 12 eventually becoming female contacts 7. The conductors 3 which extend between the separate substrate sections may be slightly scored, as at 3a, to facilitate the conductors bending as they act as the hinge means between the separate substrate sections. This scoring would assure that the bending occurs in the conductors precisely equidistant between the spaced edges 2c of the substrate sections.

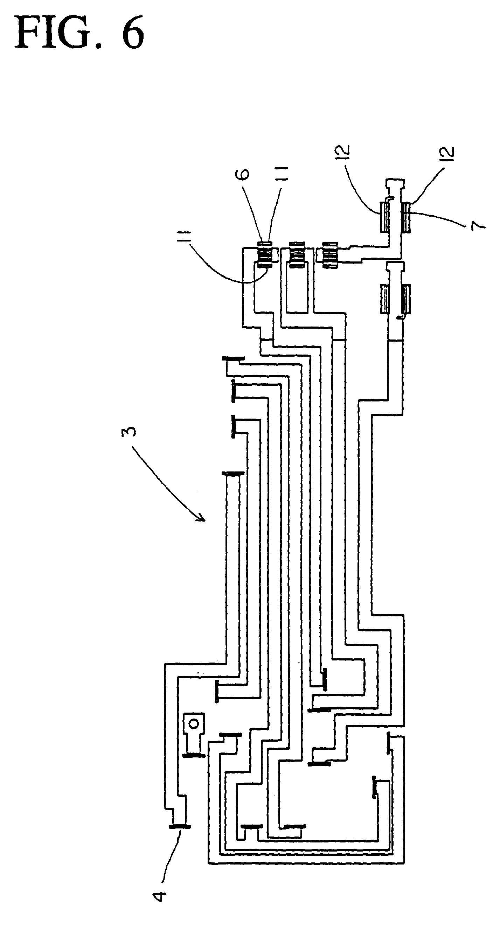

Figures 6-8 show male contacts 4 bent or formed to their final upright condition, and with arms 11 and 12 formed or bent to their upright positions to define female contacts 6 and 7, respectively. This is the configuration of the stamped and formed electrical circuitry 10 as it appears embedded within substrate 2 in Figures 1-4.

One example of a particular use of the three-dimensional molded circuit structure 1 is that a terminal block can be mounted on second substrate section 2b by using guide posts 8. The male terminals of the terminal block are mated with female contacts 6 in recesses 5 of the second substrate section. The pair of female contacts 7 can be used to interconnect opposite ends of a cylindrical fuse snapped into female contacts 7. The male contacts 4 can be connected to other male contacts or to female contacts 6 or 7, as is shown by the circuit pattern in Figure 6. The male contacts can be electrically connected to other outside electrical components or parts. Therefore, by hingedly connecting second substrate section 2b to first substrate section 2a, the second substrate section can be at a different orientation (such as exposed in a vehicular passenger compartment), while substrate section 2a is in an interior or hidden compartment for interconnection to interiorly wired electronic components.

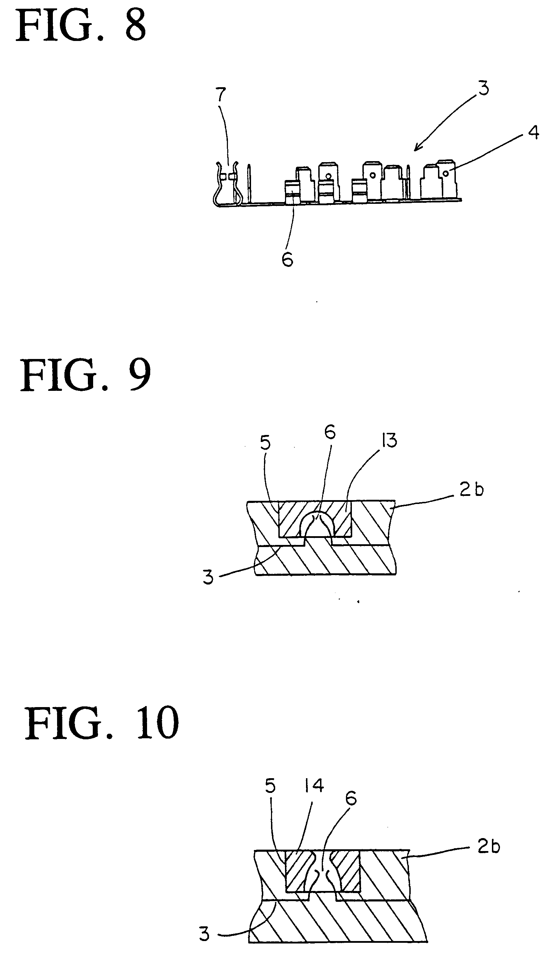

Lastly, Figure 9 shows a protection piece 13 which can be inserted into one of the recesses 5 to protect the female contact 6 therein against deformation, such as during shipping and handling. Figure 10 shows an alternate embodiment of a protection piece 14 disposed in recess 5, with the protection piece including a guide passage 14a to guide a male terminal into female contact 6.

It will be understood that the invention may be embodied in other specific forms without departing from the spirit or central characteristics thereof. The present examples and embodiments, therefore, are to be considered in all respects as illustrative and not restrictive, and the invention is not to be limited to the details given herein.

## Claims

1. A molded electrical interconnection system (1), comprising:
a three-dimensional molded dielectric substrate (2) including at least first (2a) and second (2b) separate substrate sections; and
stamped and formed electrical circuitry (10) embedded in the molded substrate and including contact portions (4,6,7) projecting from the substrate and circuit portions (3) extending between and joining said separate substrate sections (2a,2b) and allowing at least angular relative movement between the sections in response to bending of said circuit portions (3).

2. The molded electrical interconnection system of claim 1 wherein said first and second separate substrate sections (2a,2b) are generally planar.

3. The molded electrical interconnection system of claim 2 wherein at least one (2b) of said substrate sections includes at least one open socket (5) with one of said contact portions (6) of the circuitry (10) disposed therewithin.

4. The molded electrical interconnection system of claim 3 wherein said contact portion (6) in said open socket (5) comprises a formed female contact of the circuitry (10).

5. The molded electrical interconnection system of claim 1 wherein the contact portions (4) of the circuitry (10) projecting from said first substrate section (2a) comprise male contacts (4), and the contact portions (6,7) of the circuitry (10) projecting from said second substrate section (2b) comprise female contacts (6,7).

6. The molded electrical interconnection system of claim 1 wherein said substrate sections (2a,2b) are joined along generally parallel edges (2c) of the sections.

7. A molded electrical interconnection system (10), comprising: a three-dimensional molded dielectric substrate (2) including at least first (2a) and second (2b) substrate sections hingedly connected to allow at least angular relative movement between the sections; and stamped and formed electrical circuitry (10) embedded in the molded substrate (2) and including contact portions (4,6,7) projecting from the substrate and circuit portions (3) extending between said first and second substrate sections.

8. The molded electrical interconnection system of claim 7 wherein said first and second substrate sections (2a,2b) are generally planar.

9. The molded electrical interconnection system of claim 8 wherein at least one (2b) of said substrate sections includes at least one open socket (5) with one of said contact portions (6) of the circuitry (10) disposed therewithin.

10. The molded electrical interconnection system of claim 9 wherein said contact portion (6) in said open socket (5) comprises a formed female contact of the circuitry (10).

11. The molded electrical interconnection system of claim 7 wherein the contact portions (4) of the circuitry (10) projecting from said first substrate section (2a) comprise male contacts (4), and the contact portions (6,7) of the circuitry (10) projecting from said second substrate section (2b) comprise female contacts (6,7).

12. The molded electrical interconnection system of claim 7 wherein said substrate sections (2a,2b) are hinged along generally parallel edges (2c) of the sections.

13. A molded electrical interconnection system (1), comprising:
a three-dimensional molded dielectric substrate (2) including at least first (2a) and second (2b) substrate sections hingedly connected to allow at least angular relative movement between the sections; and
stamped and formed electrical circuitry (10) embedded in the molded substrate and including circuit portions (3) extending between the substrate sections, male contact portions (4) substantially entirely on one of the substrate sections (2a) and female contact portions (6,7) substantially entirely on the second substrate section (2b).

14. The molded electrical interconnection system of claim 13 wherein said first and second substrate sections (2a,2b) are generally planar.

15. The molded electrical interconnection system of claim 13 wherein said substrate sections (2a,2b) are hinged along generally parallel edges (2c) of the sections.

16. The molded electrical interconnection system of claim 13 wherein said second substrate section (2b) includes integrally molded sockets (5) within which at least some of the female contact portions (6) are disposed.
